(19) **Europäisches Patentamt European Patent Office Office européen des brevets**

(11) **EP 4 177 616 B1**

(12) **FASCICULE DE BREVET EUROPEEN**

(45) Date de publication et mention
de la délivrance du brevet:
**07.01.2026 Bulletin 2026/02**

(21) Numéro de dépôt: **22205928.9**

(22) Date de dépôt: **07.11.2022**

(51) Classification Internationale des Brevets (IPC):
**G01R 19/165** (2006.01)    **H03K 17/0812** (2006.01)
**G01R 19/00** (2006.01)    **H02H 3/08** (2006.01)
**G01R 31/52** (2020.01)

(52) Classification Coopérative des Brevets (CPC):
**G01R 19/16547; G01R 19/165; H03K 17/08128;**
G01R 19/0092; G01R 19/16519; G01R 31/52

(54) **DETECTION DE COURT-CIRCUIT ET PROTECTION D'UN COMPOSANT A GRILLE ISOLEE PAR MONITORING ET CONTROLE DE LA TENSION DE GRILLE**

KURZSCHLUSSERKENNUNG UND -SCHUTZ FÜR EIN BAUELEMENT MIT ISOLIERTEM GATE DURCH ÜBERWACHUNG UND KONTROLLE DER GATESPANNUNG

DETECTION OF A SHORT CIRCUIT AND PROTECTION OF A COMPONENT WITH INSULATED GATE BY MONITORING AND CONTROLLING THE GATE VOLTAGE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **08.11.2021 FR 2111832**

(43) Date de publication de la demande:
**10.05.2023 Bulletin 2023/19**

(73) Titulaire: **Safran Electrical & Power**
**31700 Blagnac (FR)**

(72) Inventeur: **ABDESSELAM, Francis**
**78400 Chatou (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**CN-A- 108 508 342      JP-A- 2015 053 749**
**US-A1- 2012 248 864     US-A1- 2020 212 906**
**US-A1- 2021 293 874     US-B2- 10 141 923**

## Description

Le domaine de l'invention est celui des commandes de module d'électronique de puissance permettant de piloter le fonctionnement de composants électroniques de puissance. De manière connue, les modules de puissance représentent des composants électroniques traitant de fortes puissances et présentent, de ce fait, une attention particulière dans leur conception et leur suivi en cours de vie et d'utilisation.

Plus précisément, l'invention a trait à la protection des composants de puissance à grille isolé comme les transistors de puissance à grille isolée IGBT (Insulated Gate Bipolar Transistor) ou encore les transistors à effet de champs à grille isolée MOSFET (Metal Oxide Semiconductor Field Effect Transistor).

Ces composants de puissances font, de manière connue, l'objet d'une attention particulière quant à leur état de fonctionnement afin de connaitre à chaque instant si une dégradation peut impacter ce composant. Généralement, la vérification du bon état de ce type de composant de puissance se fait par l'intermédiaire du courant le traversant les deux bornes de ces tripoles, à savoir le collecteur et l'émetteur pour un transistor IGBT ou encore le drain et la source pour un transistor de type MOS. En effet, si ces deux bornes sont traversées par un courant anormal ou un courant de court-circuit, alors il est probable que le fonctionnement du transistor, voir même l'intégrité du composant même, soit dégradé.

Actuellement, la vérification du courant traversant les deux bornes mentionnées ci-dessus se fait par l'intermédiaire d'un suivi de la tension ou du courant directement entre les deux bornes mentionnées, c'est-à-dire au niveau du canal de conduction d'un transistor.

Habituellement, cette fonction de surveillance de l'intégrité du composant de puissance, directement sur le courant traversant les deux bornes du tripole, se fait selon les moyens suivants :

- Un ajout d'un capteur de courant isolé au niveau d'une des deux bornes du transistor de puissance. A titre d'exemple indicatif, un transformateur
- positionné au niveau du collecteur (ou du drain) permet d'évaluer directement le courant traversant cette borne. Néanmoins, l'utilisation d'un capteur induit une augmentation du volume du transistor.
- La mesure du courant peut également se faire par l'intermédiaire d'une résistance positionnée en série (c'est-à-dire un shunt) par rapport à l'une des deux bornes traversées par le courant devant être mesuré. Cependant, l'utilisation d'une résistance à cet effet induit à une forte consommation de l'énergie que la résistance dissipe.
- La mesure du courant traversant le collecteur du transistor de puissance peut également se faire par l'intermédiaire d'un miroir de courant intégré au composant de puissance. Le miroir de courant est un circuit électrique permettant de copier le courant traversant le collecteur et ainsi d'avoir facilement accès à une portion de la valeur du courant traversant ce dernier. Néanmoins, ce type de circuit électrique est très spécifique à des types de composant électronique particulier. Cette architecture nécessite alors un gros investissement en termes d'adaptation.

- Il peut également être envisagé d'étudier la tension au niveau du collecteur par l'intermédiaire d'une diode. Néanmoins, cette option augmente l'encombrement global dans le transistor de puissance et présente l'inconvénient d'être aveugle par rapport à la détection d'un court-circuit pendant un temps correspondant à la transition ouvert/fermé du transistor de puissance.

Des solutions sont proposées dans les documents US 2020/212906 A1, US 2021/293874 A1, US 10 141 923 B2, US 2012/248864 A, CN 108 508 342 A ou encore JP 2015 053749 A sans être totalement satisfaisantes.

L'invention vise à pallier tout ou partie des problèmes cités plus haut en proposant un dispositif de détection d'un courant de court-circuit entre le collecteur (ou le drain) et l'émetteur (ou la source) du transistor de puissance simple, compact et présentant un coût de production relativement faible.

A cet effet, l'invention a pour objet un étage de puissance tel que défini dans la revendication 1. L'étage de puissance comprend un transistor de puissance commandé par l'intermédiaire d'un pilote, le transistor de puissance comprenant trois bornes dont un collecteur c, un émetteur e et une grille g reliée au pilote, l'étage de puissance comprenant également un dispositif de détection d'un courant de court-circuit cc entre le collecteur c et l'émetteur e, le dispositif de détection comprenant un capteur de tension apte à détecter une tension *Vge* au niveau de la grille g du transistor de puissance hors d'une plage de tension prédéfinie.

Selon un aspect de l'invention, le dispositif de détection comprend un dispositif de stockage d'énergie configuré pour délivrer une tension supplémentaire à la grille g si la capacité équivalente de la grille *Cge* est déchargée.

Selon un aspect de l'invention, le dispositif de stockage d'énergie est une inductance positionnée entre le pilote et la grille g du transistor de puissance.

Selon un aspect de l'invention, l'étage de puissance comprend un réducteur de tension apte à diminuer la tension *Vge* à la grille g jusqu'à une tension seuil.

Selon un aspect de l'invention, l'étage de puissance comprend un enregistreur apte à enregistrer un défaut de fonctionnement du transistor de puissance.

L'invention a également trait à un procédé de détection d'un courant de court-circuit cc entre un collecteur c et un émetteur e d'un transistor de puissance comprenant une grille g, le transistor de puissance étant compris dans l'étage de puissance selon la revendication 1, le procédé comprenant les étapes suivantes :

- Détection d'une tension *Vge à* la grille *g* du transistor de puissance hors d'une plage de tension prédéfinie,
- Réduction de la tension à la grille *g* du transistor de puissance à une tension de réduction prédéfinie,
- Ouverture du transistor de puissance.

L'invention présente l'avantage de permettre l'analyse du courant entre le collecteur et l'émetteur d'un transistor de puissance par le monitoring de la tension de grille du transistor de puissance par l'intermédiaire d'un dispositif de détection compact et de conception simple.

L'invention sera mieux comprise et d'autres avantages apparaîtront à la lecture de la description détaillée d'un mode de réalisation donné à titre d'exemple, description illustrée par le dessin joint dans lequel :

[Fig.1] la figure 1 représente un étage de puissance comprenant un transistor de puissance et un dispositif de détection d'un courant de court-circuit selon l'invention ;

[Fig.2] la figure 2 représente un procédé de détection d'un courant de court-circuit entre un drain et une source d'un transistor de puissance selon l'invention.

[Fig.3] la figure 3 représente le procédé de détection d'un courant de court-circuit par l'intermédiaire d'un chronogramme.

Par souci de clarté, les mêmes éléments porteront les mêmes repères dans les différentes figures.

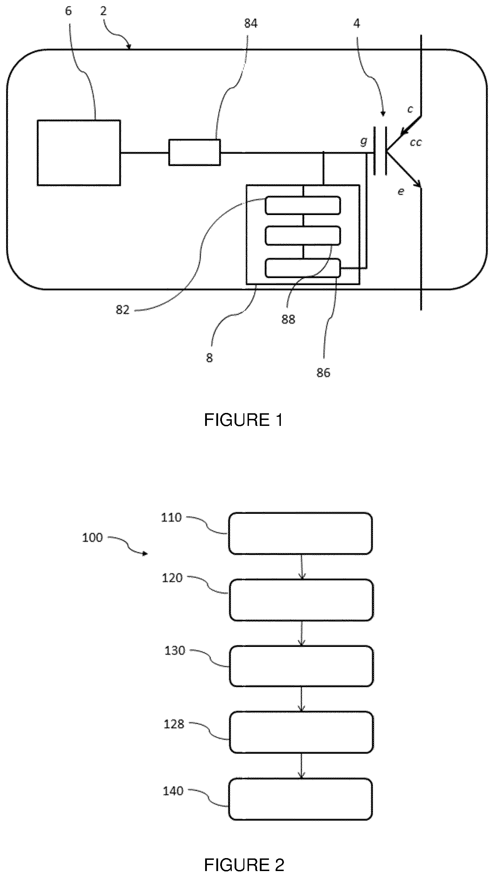

La figure 1 représente un étage de puissance 2 comprenant un transistor de puissance 4 commandé par l'intermédiaire d'un pilote 6. Le transistor de puissance 4 comprend trois bornes dont un collecteur c, un émetteur e et une grille g reliée au pilote 6. Le transistor de puissance de puissance 4 est un transistor bipolaire à grille isolée (IGBT, de l'anglais *Insulated Gate Bipolar Transistor*). En variante, le transistor de puissance 4 est un transistor à effet de champ (en anglais, *metal oxide semiconductor Field-effect transistor* ou *MOSFET*) et comprend donc un drain, une source et une grille reliée au pilote 6. Dès lors, pour un transistor à effet de champ, le drain peut être assimilé au collecteur c, la source peut être assimilée à l'émetteur e.

Dans ce contexte, l'invention consiste à détecter et à protéger le composant de puissance à grille isolée, à savoir le transistor de puissance 4, lorsque celui-ci est traversé par un courant anormal. Ce courant anormal nommé « courant de court-circuit », apparaît lorsqu'une impédance basse nommée « court-circuit » est présente aux bornes d'une source électrique et comprend une intensité supérieure à une intensité prédéfinie pour un fonctionnement dit « normal » du transistor de puissance 4. Ce courant de court-circuit peut être de deux types :

- Un court-circuit de type 1 qui est un court-circuit appliqué pendant conduction du transistor de puissance 4, c'est-à-dire lorsque le courant anormal se superpose à un courant normal. Dès lors, lors d'un court-circuit de type 1, une tension mesurée entre la grille *g* et l'émetteur e du transistor de puissance 4, nommée tension de grille *Vge,* du transistor de puissance 4 augmente rapidement et dans la même proportion que l'augmentation du courant de court-circuit.

- Un court-circuit de type 2 qui est un court-circuit établi avant la mise en conduction du transistor de puissance 4. Dès lors, lorsque le transistor de puissance 4 entre en conduction, le courant anormal ou courant de court-circuit traverse immédiatement le transistor de puissance 4. Lors d'un court-circuit de type 2, la capacité équivalente *Cge* vue de la grille *g* du transistor de puissance 4 reste constante et de faible valeur en comparaison d'une capacité équivalente mesuré à la grille du transistor de puissance 4 lors d'un fonctionnement dit « normal ».

Autrement dit, le court-circuit de type 1 et le court-circuit de type 2 sont tous les deux liés à un circuit extérieur au transistor de puissance 4, formant une boucle électrique fermée et comprenant une charge électrique, raccordé au transistor de puissance 4 par l'intermédiaire du collecteur c et de la émetteur e. Ainsi, un court-circuit de type 1 est un court-circuit apparaissant dans ce circuit extérieur alors que le transistor de puissance 4 est déjà en conduction alors qu'un court-circuit de type 2 est un court-circuit déjà présent dans le circuit extérieur avant que la conduction du transistor de puissance 4 soit établie.

Ainsi, l'étage de puissance 2 comprend un dispositif de détection 8 d'un courant de court-circuit *cc* entre le collecteur c et l'émetteur e. Le dispositif de détection 8 comprend un capteur de tension 82 apte à détecter et à mesurer la tension entre la grille *g* et l'émetteur *e* nommée *Vge* au niveau de la grille *g* du transistor de puissance 4. Plus précisément, le capteur de tension 82 est configuré pour comparer cette mesure de tension de grille *Vge à* une plage de tension définie, et signaler si la mesure de tension de grille *Vge est* hors de la plage de tension prédéfinie. En effet, la présence d'un court-circuit dans le transistor de puissance 4 et particulièrement entre le collecteur c et l'émetteur e peut se traduire par une augmentation significative de l'intensité du courant entre ces deux bornes du transistor de puissance 4 et induit la dégradation de l'étage de puissance 2. Or, cette surtension induite par l'augmentation du courant qui traverse le transistor de puissance 4 s'exprime selon la formule suivante :

$$\Delta Vg = \frac{\Delta Ids}{Gm}$$

Où $\Delta Vg$ représente la variation de tension *Vge à*

la grille, $\Delta Ids$ représente la variation du courant entre le collecteur c et l'émetteur e et *Gm* représente la transconductance du transistor de puissance 4. A titre d'exemple indicatif, la transconductance *Gm* est égale à 300 Siemens par exemple.

Dès lors, il est possible d'observer une relation proportionnelle, pour une même transconductance du transistor de puissance 4, entre la tension *Vge à* la grille et le courant entre le collecteur c et l'émetteur e. Plus précisément, lors d'une augmentation significative de l'intensité du courant entre le collecteur c et l'émetteur e, synonyme de courant de court-circuit *cc,* la tension *Vge à* la grille subit également une augmentation de la mesure de tension réalisée au moyen d'un capteur de tension 82. Le capteur de tension 82, qui est relié directement à la grille *g,* permet donc de mesurer la tension *Vge à* la grille *g* de sorte à pouvoir détecter un courant de court-circuit cc entre le collecteur c et l'émetteur e du transistor de puissance 4.

A titre d'exemple la plage de tension prédéfinie dans laquelle la tension *Vge* de la grille g est comprise est une plage de tension comprise entre 0 Volts et +20 Volts. En variante, cette plage de tension prédéfinie est une plage de tension comprise entre 2 Volts et 20 Volts dans le cas d'utilisation d'un transistor à effet de champs à grille isolée MOSFET. Selon une autre variante, pour le cas d'utilisation d'un transistor de puissance à grille isolée IGBT, la plage de tension prédéfinie est une plage de tension comprise entre 5 Volts et 20 Volts.

En outre, le court-circuit peut également être présent avant la mise en conduction du transistor de puissance 4 dans le cas d'un court-circuit de type 2.

Lorsque le transistor de puissance entre en conduction, un courant anormal, ou autrement dit un courant de court-circuit, traverse immédiatement le transistor de puissance. Et, la valeur de tension à la grille mesurable n'augmente pas aussi rapidement et n'est pas aussi importante que pour un court-circuit de type 1. Dès lors, la simple mesure de la tension à la grille *Vge* ne suffit plus puisque cette mesure peut se faire tardivement. Or, lors d'un court-circuit, la capacité équivalente vue de la grille *g* du transistor de puissance reste constante et de faible valeur, soit environ dix fois plus faible que lorsqu'un courant « normal » traverse le transistor de puissance. A l'inverse, en fonctionnement normal, c'est-à-dire lorsque le transistor de puissance est saturé, la valeur de la capacité, vue de la grille *g,* est augmentée, notamment à cause de l'effet de Miller, lorsque la tension mesurée au collecteur *c* est basse. Cette capacité équivalente mesurée à la grille *g* est de valeur élevée, et généralement supérieur à un microfarad, aux instants de commutation. Et, en court-circuit, l'instant de commutation n'impacte alors pas la valeur de la capacité de grille équivalente. La valeur de la capacité de grille équivalente reste constante et de valeur faible, c'est-à-dire inférieure à cent nanofarad. Cette évolution peut se comprendre comme étant l'évolution des charges à la grille.

Dès lors, la variation de la tension $\Delta Vg$ au

niveau de la grille *g* n'est pas assez significative afin de mettre en évidence un courant de court-circuit *cc* présent lors de cette phase de transition. Afin de mettre en évidence ce type de court-circuit, le dispositif de détection 8 comprend un capteur de mesure de capacité 83 apte à détecter et à mesurer une valeur de capacité équivalente *Cge* de la grille *g* au niveau de la grille *g* du transistor de puissance 4. Plus précisément, le capteur de capacité 83 est configuré pour comparer cette mesure de capacité équivalente de grille *Cge* à une valeur de capacité prédéfinie, et signaler si la mesure de capacité équivalente de grille *Cge* est inférieure à la valeur de capacité prédéfinie. Autrement dit, lorsque la capacité équivalente de la grille *Cge,* entre la grille *g* et le canal de conduction, est déchargée, le capteur de mesure de capacité 83 est apte à détecter cette valeur de capacité équivalente *Cge,* mesurer cette valeur de capacité équivalente *Cge,* comparer cette valeur de capacité équivalente *Cge* avec la valeur de capacité prédéfinie normalement mesurable et signaler le disfonctionnement. En effet, dans un fonctionnement nominal du transistor de puissance 4, c'est-à-dire aux instants de commutation, la capacité équivalente de la grille *Cge* est transitoirement de valeur élevée, c'est-à-dire par exemple supérieure à 1 μF. A l'inverse, lorsque la conduction du transistor de puissance 4 est établie, la capacité équivalente de la grille *Cge* est de valeur faible, c'est-à-dire par exemple environ 100 nF. Dès lors, lorsque la mesure de la capacité équivalente *Cge* au niveau de la grille *g* du transistor de puissance est inférieure à cette valeur faible de capacité équivalente pour un fonctionnement en conduction du transistor de puissance 4, un court-circuit de type 2 est détecté. A titre d'exemple indicatif, la valeur de capacité prédéfinie peut être une valeur de capacité de 100 nF.

A titre d'exemple indicatif, le capteur de mesure de capacité 83 peut être un pont de Wheatstone.

En variante, il peut également être envisagé de mesurer cette valeur de capacité équivalente de la grille *Cge* selon la formule suivante :

$$C_{ge} = \frac{Q_{ge}}{V_{ge}}$$

Où $Q_{ge}$ représente la charge de grille et $V_{ge}$ représente la tension entre la grille et l'émetteur. La charge Qge peut être définie en intégrant, par rapport au temps, l'intensité du courant traversant la grille *g.* De plus, la valeur de la tension à la grille Vge est déjà connue par le biais du capteur de tension 82. Ainsi, le capteur de mesure de capacité 83 peut également être un dispositif de mesure de l'intensité du courant à la grille *g* configuré pour déterminer, selon la formule précédente, la valeur de capacité équivalente de la grille *Cge.*

Le dispositif de détection 8 comprend également un dispositif de stockage d'énergie 84 configuré pour délivrer une tension supplémentaire à la grille *g* lorsque la valeur de capacité équivalente mesurée à la grille *Cge* par le capteur de mesure de capacité 83 est inférieure à la valeur de capacité prédéfinie à la grille *g*. Autrement dit, lorsque le capteur de mesure de capacité 83 détecte que la valeur de capacité équivalente mesurée à la grille *Cge* est inférieure à la valeur de capacité prédéfinie à la grille *g,* le capteur de mesure de capacité 83 pilote le dispositif de stockage d'énergie 84 de sorte que le dispositif de stockage d'énergie 84 libère une tension supplémentaire à la grille *g*. Or, la libération de cette tension supplémentaire à la grille *g* permet alors de générer une surtension au niveau de la grille *g*. Dès lors, la tension *Vge* entre la grille *g* et l'émetteur e augmente de façon proportionnelle à la tension supplémentaire délivrée par le dispositif de stockage 84 jusqu'à dépasser la plage de tension prédéfinie. Dès lors, le capteur de tension 82 détecte que la tension *Vge* au niveau de la grille *g* du transistor de puissance 4 est hors de la plage de tension prédéfinie et signale donc un court-circuit dans le transistor de puissance 4 permettant d'ouvrir le transistor de puissance 4 avant une dégradation de ses composants. Le dispositif de stockage d'énergie 84 est positionné entre le pilote 6 et la grille *g* du transistor de puissance 4 de sorte à pouvoir délivrer la tension supplémentaire à la grille *g*. A titre d'exemple indicatif, cette tension supplémentaire est la tension nécessaire pour que la somme de la tension mesurée à la grille *g* et de la tension supplémentaire soit supérieure à la valeur de tension maximale de la plage de tension prédéfinie.

A titre d'exemple indicatif, le dispositif de stockage d'énergie 84 est une inductance, d'une valeur d'inductance d'environ 100 nH, positionnée entre le pilote 6 et la grille *g* du transistor de puissance 4. L'inductance présente l'avantage d'être un composant passif permettant de répondre directement à un signal en créneau fourni par le pilote 6 et de permettre le stockage et la restitution de l'énergie suffisante pour induire une surtension, lorsque la capacité équivalente vue de la grille du transistor de puissance 4 est faible et déchargée.

En variante, le dispositif de stockage 84 est un générateur actif permettant de générer une tension supplémentaire à la grille et piloté par une information du pilote 6.

Dans la suite de la description, le dispositif de stockage 84 est assimilé à une inductance 84. Ainsi, comme dit précédemment, l'inductance 84 est positionnée en série entre le pilote 6 et la grille *g* de sorte à réaliser un circuit résonant RLC entre le pilote 6, par l'intermédiaire d'une résistance comprise dans le pilote 6, l'inductance 84 et la capacité de la grille *g* et donc connaître l'amortissement du système. Or, la relation suivante permet de mettre en évidence un sous-amortissement du circuit résonant RLC permettant à l'inductance 84 d'injecter la tension supplémentaire à la grille g selon la condition :

$$\frac{Rg}{2}\sqrt{\frac{Cge\_cc}{L}} < 1$$

Où *Rg* représente la résistance du pilote 6 dans le circuit résonant RLC, *Cge_cc* représente la capacité équivalente de la grille *g* lorsque le transistor de puissance 4 subit un court-circuit et *L* représente la valeur d'inductance de l'inductance 84.

Dès lors, l'inductance 84 présente l'avantage de permettre un apport supplémentaire de tension au niveau de la grille *g* du transistor de puissance de sorte à mettre en évidence le fait que la valeur de la tension *Vge* de la grille *g* n'est pas comprise dans la plage de tension et donc la présence d'un courant de court-circuit cc pendant cette phase de transition du transistor de puissance 4.

De plus, l'étage de puissance 2 comprend un réducteur de tension 86 apte à diminuer la tension *Vge à* la grille *g* jusqu'à une tension seuil, lorsqu'un courant de court-circuit cc est détecté entre le collecteur c et l'émetteur e par l'intermédiaire du capteur de tension 82. Plus précisément, lorsque la tension *Vge à* la grille *g* détectée par le capteur de tension 82 n'est pas comprise dans la plage de tension prédéfinie, le réducteur de tension 86 permet de réduire cette tension *Vge à* la grille *g* afin d'être comprise dans la plage de tension. A titre d'exemple, la tension seuil peut être une tension inférieure à 20 Volts et/ou supérieure à la tension à laquelle le transistor de puissance entre en conduction, nommée Vgsth, et est préférentiellement une tension de 10 Volts. Le réducteur de tension 86 présente l'avantage de pouvoir diminuer le courant de court-circuit selon la relation

$$\Delta Vg = \frac{\Delta Ids}{Gm}$$ , avant d'ouvrir le transistor de puissance 4.

L'étage de puissance 2 comprend également un enregistreur 88 apte à enregistrer le court-circuit du transistor de puissance 4. A titre d'exemple, l'enregistreur 88 est un condensateur qui se décharge à la suite du court-circuit afin de mettre en évidence un défaut de fonctionnement du transistor de puissance 4.

Il est également proposé un procédé de détection 100, représenté en figure 2, d'un courant de court-circuit cc entre un collecteur c et un émetteur e d'un transistor de puissance 4, comprenant une grille *g*. Le procédé de détection 100 comprend les étapes suivantes :

- Détection (étape 120) de la tension *Vge* à la grille *g* du transistor de puissance 4 hors de la plage de tension prédéfinie. A titre d'exemple la plage de tension prédéfinie dans laquelle la tension *Vge* de la grille *g* est comprise est une plage de tension comprise entre 0 Volts et +20 Volts. La détection 120 de la tension *Vge* est effectuée par l'intermédiaire du capteur de tension 82.

- Réduction de la tension (étape 130) à la grille *g* du transistor de puissance 4 à une tension prédéfinie. A titre d'exemple préférentiel, la tension prédéfinie de réduction peut être de 10 Volts.

- Ouverture (étape 140) du transistor de puissance 4.

La réduction de la tension (étape 130) à la grille *g* du transistor de puissance 4 peut induire une ouverture (étape 140) automatique du transistor de puissance 4. En variante, cette ouverture (étape 140) peut être commandée. Néanmoins, la commande de l'ouverture 140 du transistor de puissance 4 doit être prompte.

Le procédé de détection 100 peut également comprendre une étape de restitution (étape 110) d'une énergie supplémentaire en amont de l'étape de détection 120 si la capacité équivalente de la grille *Cge* est déchargée et inférieure à la capacité prédéfinie c'est-à-dire par exemple une capacité d'environ 100 nF.

L'étape de restitution 110 de l'énergie stockée à la grille *g* permet d'apporter l'énergie supplémentaire mettant en évidence un court-circuit lors de la mise en commutation du transistor de puissance 4.

Le procédé de détection 100 peut également comprendre, à la suite de l'étape de détection 120, une étape d'enregistrement du défaut (étape 128) du transistor de puissance 4.

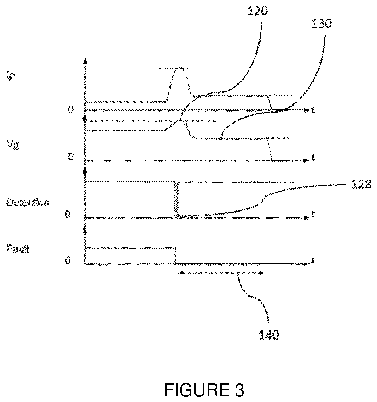

Le procédé de détection 100 peut également être interprété selon le chronogramme représenté en figure 3. En effet, un courant de court-circuit au niveau du transistor de puissance 4 peut être interprété comme une forte augmentation du courant Ip traversant le transistor de puissance 4. Or, dans le cas d'un court-circuit de type 1, cette augmentation du courant est accompagnée d'une augmentation de la tension *Vge* à la grille *g* du transistor de puissance 4. Dès lors, la détection 120 se fait lorsque la tension *Vge* est supérieure à 20 Volts par exemple. S'en suit alors, afin de ne pas endommager le transistor de puissance 4, la réduction de la tension *Vge* (étape 130) à la grille *g* du transistor de puissance 4 à la tension prédéfinie, comme par exemple 10 Volts et l'ouverture 140 du transistor de puissance 4. Dans le cas d'un court-circuit de type 2, la restitution 110 l'énergie suffisante pour induire la surtension, si la capacité équivalente de la grille *Cge* est déchargée et inférieure à la capacité prédéfinie c'est-à-dire par exemple une capacité d'environ 100 nF, permet de générer la détection 120 cette surtension à la grille. De plus, l'étape d'enregistrement du défaut 128 permet, dès la détection 120 du défaut de fonctionnement du transistor de puissance 4, de mémoriser le défaut en temps réel.

L'invention propose donc d'intégrer un capteur de tension au niveau de la grille du transistor de puissance afin de détecter une tension anormale, c'est-à-dire une tension hors d'une plage de tension prédéfinie pour la grille *g* et d'intégrer un moyen permettant de stocker et de restituer l'énergie suffisante pour induire une détection d'une tension anormale, lorsque la capacité *Cge* équivalente vue de la grille du transistor de puissance 4 est déchargée pour le cas d'un court-circuit de type 2.

L'invention présente donc de pouvoir détecter un court-circuit dans le transistor de puissance à partir de la mesure de la tension à la grille du transistor de puissance.

**Revendications**

1. Etage de puissance (2) comprenant un transistor de puissance (4) commandé par l'intermédiaire d'un pilote (6), le transistor de puissance (4) comprenant trois bornes dont un collecteur c, un émetteur e et une grille *g* reliée au pilote (6), l'étage de puissance (2) comprenant un dispositif de détection (8) d'un courant de court-circuit cc entre le collecteur c et l'émetteur e, le dispositif de détection (8) comprenant un capteur de tension (82) apte à détecter une tension *Vge* au niveau de la grille *g* du transistor de puissance (4) hors d'une plage de tension prédéfinie, le dispositif de détection (8) comprenant un capteur de mesure de capacité (83) configuré pour mesurer une valeur de capacité équivalente *Cge* à la grille *g* du transistor de puissance (4) et comparer la valeur de capacité équivalente de grille *Cge* à une valeur de capacité prédéfinie, l'étage de puissance (2) étant **caractérisé en ce que** le dispositif de détection (8) comprend un dispositif de stockage d'énergie (84) configuré pour délivrer une tension supplémentaire à la grille *g* si le capteur de mesure de capacité (83) détecte que la valeur de la capacité équivalente de la grille *Cge* est inférieure à la valeur de capacité prédéfinie.

2. Etage de puissance (2) selon la revendication 1, dans lequel le dispositif de stockage d'énergie (84) est une inductance positionnée entre le pilote (6) et la grille *g* du transistor de puissance (4).

3. Etage de puissance (2) selon l'une des revendications 1 à 2, comprenant un réducteur de tension (86) apte à diminuer la tension *Vge* à la grille *g* jusqu'à une tension seuil.

4. Etage de puissance (2) selon l'une des revendications 1 à 3, comprenant un enregistreur (88) apte à enregistrer un défaut de fonctionnement du transistor de puissance (4).

5. Procédé de détection (100) d'un courant de court-circuit cc entre un collecteur c et un émetteur e d'un transistor de puissance (4) comprenant une grille *g*, le transistor de puissance (4) étant compris dans l'étage de puissance (2) selon la revendication 1, le procédé (100) comprenant les étapes suivantes :

- Détection (120) d'une tension *Vge* à la grille *g* du transistor de puissance (4) hors d'une plage de tension prédéfinie,

- Réduction de la tension (130) à la grille *g* du transistor de puissance (4) à une tension de réduction prédéfinie,
- Ouverture (140) du transistor de puissance (4).

**Patentansprüche**

1. Leistungsstufe (2), umfassend einen Leistungstransistor (4), der mittels eines Piloten (6) gesteuert wird, wobei der Leistungstransistor (4) drei Anschlüsse eines Stromabnehmers c, einen Emitter e und ein mit dem Piloten (6) verbundenes Gate g umfasst, wobei die Leistungsstufe (2) eine Detektionsvorrichtung (8) eines Kurzschlussstroms cc zwischen dem Stromabnehmer c und dem Emitter e umfasst, wobei die Detektionsvorrichtung (8) einen Spannungssensor (82) umfasst, der in der Lage ist, eine Spannung *Vge* auf Höhe des Gates g des Leistungstransistors (4) außerhalb eines vordefinierten Leistungsbereichs zu detektieren, wobei die Detektionsvorrichtung (8) einen Kapazitätsmessungssensor (83) umfasst, der zum Messen eines äquivalenten Kapazitätswerts *Cge* an dem Gate g des Leistungstransistors (4) und zum Vergleichen des äquivalenten Kapazitätswerts *Cge* mit einem vordefinierten Kapazitätswert konfiguriert ist, wobei die Leistungsstufe (2) **dadurch gekennzeichnet ist, dass** die Detektionsvorrichtung (8) eine Energiespeichervorrichtung (84) umfasst, die zum Abgeben einer zusätzlichen Spannung an das Gate g konfiguriert ist, wenn der Kapazitätsmessungssensor (83) detektiert, dass der Wert der äquivalenten Kapazität des Gates *Cge* kleiner ist als der vordefinierte Kapazitätswert.

2. Leistungsstufe (2) nach Anspruch 1, wobei die Energiespeichervorrichtung (84) eine zwischen dem Piloten (6) und dem Gate g des Leistungstransistors (4) positionierte Induktivität ist.

3. Leistungsstufe (2) nach einem der Ansprüche 1 bis 2, umfassend einen Spannungsteiler (86), der in der Lage ist, die Spannung *Vge* an dem Gate g bis auf eine Schwellenspannung zu verringern.

4. Leistungsstufe (2) nach einem der Ansprüche 1 bis 3, umfassend einen Datenrekorder (88), der in der Lage ist, einen Funktionsfehler des Leistungstransistors (4) aufzuzeichnen.

5. Detektionsverfahren (100) für einen Kurzschlussstrom cc zwischen einem Stromabnehmer c und einem Emitter e eines Leistungstransistors (4), der ein Gate *g* umfasst, wobei der Leistungstransistor (4) in der Leistungsstufe (2) nach Anspruch 1 umfasst ist, wobei das Verfahren (100) die folgenden Schritte umfasst:

- Detektion (120) einer Spannung *Vge* an dem Gate g des Leistungstransistors (4) außerhalb eines vordefinierten Spannungsbereichs,
- Reduktion der Spannung (130) an dem Gate g des Leistungstransistors (4) auf eine vordefinierte Reduktionsspannung,
- Öffnung (140) des Leistungstransistors (4).

**Claims**

1. Power stage (2) comprising a power transistor (4) controlled via a driver (6), the power transistor (4) comprising three terminals including a collector c, an emitter e and a gate g linked to the driver (6), the power stage (2) comprising a detection device (8) for detecting a short-circuit current cc between the collector c and the emitter e, the detection device (8) comprising a voltage sensor (82) capable of detecting a voltage *Vge* at the gate g of the power transistor (4) outside of a predefined voltage range, the detection device (8) comprising a capacitance measurement sensor (83) configured to measure an equivalent capacitance value *Cge* at the gate g of the power transistor (4) and compare the gate equivalent capacitance value *Cge* to a predefined capacitance value, the power stage (2) being **characterized in that** the detection device (8) comprises an energy storage device (84) configured to deliver an additional voltage to the gate g if the capacitance measurement sensor (83) detects that the value of the gate equivalent capacitance *Cge* is lower than the predefined capacitance value.

2. Power stage (2) according to claim 1, wherein the energy storage device (84) is an inductor positioned between the driver (6) and the gate g of the power transistor (4).

3. Power stage (2) according to any one of claims 1 to 2, comprising a voltage reducer (86) capable of reducing the voltage *Vge* at the gate *g* to a threshold voltage.

4. Power stage (2) according to any one of claims 1 to 3, comprising a recorder (88) capable of recording an operating fault in the power transistor (4).

5. Detection method (100) for detecting a short-circuit current cc between a collector c and an emitter e of a power transistor (4) comprising a gate *g,* the power transistor (4) being included in the power stage (2) according to claim 1, the method (100) comprising the following steps:

- detecting (120) a voltage *Vge* at the gate g of the power transistor (4) outside of a predefined voltage range,

- reducing (130) the voltage at the gate *g* of the power transistor (4) to a predefined reduction voltage,
- switching off (140) the power transistor (4).

FIGURE 1

FIGURE 2

FIGURE 3

## RÉFÉRENCES CITÉES DANS LA DESCRIPTION

**Documents brevets cités dans la description**

- US 2020212906 A1
- US 2021293874 A1
- US 10141923 B2
- US 2012248864 A
- CN 108508342 A
- JP 2015053749 A